(19)

Europäisches
Patentamt
European
Patent Office
Office européen
des brevets

(11) **EP 4 386 574 A1**

(12) **EUROPEAN PATENT APPLICATION**

(43) Date of publication:
**19.06.2024 Bulletin 2024/25**

(21) Application number: **22306928.7**

(22) Date of filing: **16.12.2022**

(51) International Patent Classification (IPC):
***G06F 16/22*** $^{(2019.01)}$       ***H03M 7/40*** $^{(2006.01)}$

(52) Cooperative Patent Classification (CPC):
**G06F 16/2237; G06F 16/2246; H03M 7/3066**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Dassault Systèmes**
**78140 Vélizy-Villacoublay (FR)**

(72) Inventors:
- **VALLET GLENISSON, Eric**
  **78946 Vélizy-Villacoublay Cedex (FR)**
- **SAHUT D'IZARN Jean-Philippe**
  **78946 Vélizy-Villacoublay Cedex (FR)**

(74) Representative: **Bandpay & Greuter**
**11 rue Christophe Colomb**
**75008 Paris (FR)**

(54) **DATA STRUCTURE FOR EFFICIENT GRAPH DATABASE STORAGE**

(57)     The disclosure notably relates to a computer-implemented method of storing RDF graph data in a graph database comprising a set of RDF tuples. The method comprises obtaining one or more adjacency matrices wherein each adjacency matrix represents a group of tuples of the graph database comprising a same predicate. The method further comprises storing, for each of the one or more adjacency matrices, a data structure comprising an array. The array comprises one or more indices each pointing to a sub-division of the adjacency matrix, and/or one or more elements each representing a group of tuples of the RDF graph database of a respective sub-division of the adjacency matrix.

obtaining one or more adjacency matrices, each adjacency matrix representing a group of tuples of the graph database comprising a same predicate

S10

storing, for each of the one or more adjacency matrices, a data structure comprising an array (NV), the array comprising one or more indices each pointing to a sub-division of the adjacency matrix, and/or one or more elements each representing a group of tuples of the RDF graph database of a respective sub-division of the adjacency matrix.

S20

## FIG. 1

EP 4 386 574 A1

**Description**

**TECHNICAL FIELD**

The disclosure relates to the field of computer programs and systems, and more specifically to a method, system and program for storing RDF graphs data in a graph database comprising a set of RDF tuples.

**BACKGROUND**

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Furthermore, a number of solutions for database management are offered for application of the above design systems and programs in In-memory databases, i.e., purpose-built databases that rely primarily on memory for data storage, in contrast to databases that store data on disk or SSDs. Among such database management solutions, the solutions related to graph databases, for example RDF graph database, are of particular interest due to their great flexibility in data modeling and data storage. In general applications, RDF graph databases need to be capable of handling large datasets of billions of tuples and in size of terabytes (e.g., Microsoft Academic Knowledge Graph. Retrieved May 10, 2022, from https://makg.org/rdf-dumps with over 8 billion triples requiring 1.2TB of storage in the standard TTL format). Known solutions in the art propose data compression techniques (https://en.wikipedia.org/wiki/Data_compression) to reduce the required size of storage (e.g., in a memory or on a disk) for such graphs. Such compression techniques serve to reduce storage cost (e.g., hardware cost) and environmental footprint in various applications, notably in cloud deployment.

Document ÁLVAREZ-GARCÍA, S., et al., "Compressed vertical partitioning for efficient RDF management.", Knowledge and Information Systems, 2015, vol. 44, no 2, p. 439-474, discloses an RDF indexing technique that supports SPARQL solution in compressed space. The disclosed technique, called k2-triples, uses the predicate to vertically partition the dataset into disjoint subsets of pairs (subject, object), one per predicate. These subsets are represented as binary matrices of subjects × objects in which 1-bits mean that the corresponding triple exists in the dataset. This model results in very sparse matrices, which are efficiently compressed using k2-trees.

Document CHATTERJEE, A., et al., "Exploiting topological structures for graph compression based on quadtrees.", In: 2016 Second International Conference on Research in Computational Intelligence and Communication Networks (ICRCICN). IEEE, 2016. p. 192-197, discloses algorithms that take into consideration the properties of graphs, and perform compression based on quadtrees. Furthermore, techniques to both compress data and also perform queries on the compressed data itself are introduced and discussed in detail.

Document NELSON, M., et al., "Queryable compression on streaming social networks.", In: 2017 IEEE International Conference on Big Data (Big Data). IEEE, 2017. p. 988-993, discloses the use of a novel data structure for streaming graphs that is based on an indexed array of compressed binary trees that builds the graph directly without using any temporary storage structures. The data structure provides fast access methods for edge existence (does an edge exist between two nodes?), neighbor queries (list a node's neighbors), and streaming operations (add/remove nodes/edges).

Within this context, there is still a need for an improved method for storing RDF graph data in a graph database comprising a set of RDF tuples.

**SUMMARY**

It is therefore provided a computer-implemented method of storing RDF graph data in a graph database comprising a set of RDF tuples. The method comprises obtaining one or more adjacency matrices wherein each adjacency matrix represents a group of tuples of the graph database comprising a same predicate. The method further comprises storing, for each of the one or more adjacency matrices, a data structure comprising an array. The array comprises one or more indices each pointing to a sub-division of the adjacency matrix, and/or one or more elements each representing a group of tuples of the RDF graph database of a respective sub-division of the adjacency matrix.

The method may comprise one or more of the following:

- each of the one or more elements of the array comprises a set of one or more coordinate pairs wherein each pair represents respective coordinates in the adjacency matrix;
- an element of the one or more elements comprises a data structure of 32-bit indices, and with a layout comprising a tag representing the size and/or a type of the data structure, and one or more pairs of coordinates comprising a row and a column of the adjacency matrix;
- an element of the one or more elements comprises a data structure of 16-bit indices with a layout comprising a tag representing the size and/or a type of the data structure, and one or more pairs of coordinates comprising a base column, a base row, an offset column, and an offset row of the adjacency matrix;
- an element of the one or more elements comprises a data structure of 8-bit indices with a layout comprising a tag representing the size and/or a type of the data structure, and one or more pairs of coordinates comprising a base column, a base row, an offset column, and an offset row of the adjacency matrix;
- an element of the one or more elements comprises a data structure of m-bit indices, the method further comprising determining a tag corresponding to the element and based on the one or more pairs of coordinates, the tag representing the size and/or a type of a data structure;
- the stored data structure further comprising a bit array (BM) of bitmap representation of a group of RDF tuples in a respective sub-division of the adjacency matrix;
- the array of the stored data structure being a 2D array of size $2^n \times 2^n$ or a 1D array of size $2^{2n}$, n being a positive integer;
- the storing the data structure comprises allocating a slot thereby obtaining a root index, the root index representing a location of the tree data structure in a memory; and setting the array at the root index to an array of coordinate pairs;
- the method of storing an RDF graph further comprises implementing one or more of the following functions on the RDF graph database, each function being configured to apply on each adjacency matrix of the one or more adjacency matrices:

  ◦ a function (Test) configured to check if a given cell of the adjacency matrix is set to a first specified value,
  ◦ a function (Set) configured to set a given cell of the adjacency matrix to a first specified value,
  ◦ a function (Reset) configured to set a given cell of the adjacency matrix to a second specified value,
  ◦ a function (ScanAll) configured to output respective coordinates of all cells of the adjacency matrix with a first specified value,
  ◦ a function (ScanRow) configured to output respective coordinates of cells of a given row in the adjacency matrix with a first specified value, and/or
  ◦ a function (ScanColumn) configured to output respective coordinates of cells of a given column in the adjacency matrix with a first specified value; and/or

- the obtaining one or more adjacency matrices comprises performing a vertical partitioning for each predicate of the graph database.

It is further provided a computer program comprising instructions for performing the method.
It is further provided a computer readable storage medium having recorded thereon the computer program.
It is further provided a system comprising a processor coupled to a memory and, the memory having recorded thereon the computer program.

## BRIEF DESCRIPTION OF THE DRAWINGS

Non-limiting examples will now be described in reference to the accompanying drawings, where

- FIG. 1 shows a flowchart of an example of the method;
- FIG. 2 shows an example of the system;
- FIG.s 3A-B show examples of 32-byte data structure according to the method;
- FIG. 4 shows an example of 16-byte data structure according to the method;
- FIG. 5 shows an example of 8-byte data structure according to the method; and
- FIG.s 6A-6B show a comparative effect of the index size on the maximum capacity.

**DETAILED DESCRIPTION**

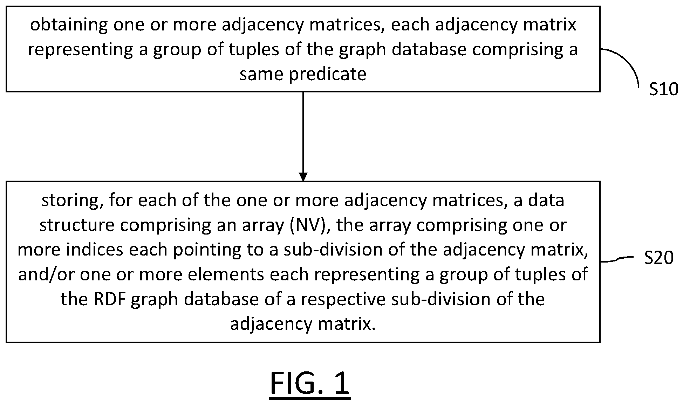

With reference to the flowchart of FIG. 1, it is proposed a computer-implemented method of storing RDF graphs data in a graph database which comprises a set of RDF tuples. The method comprises obtaining one or more adjacency matrices, and storing, for each of the one or more adjacency matrices, a data structure comprising an array. Each adjacency matrix represents a group of tuples of the graph database comprising a same predicate. The array comprises one or more indices each pointing to a sub-division of the adjacency matrix, and/or one or more elements each representing a group of tuples of the RDF graph database of a respective sub-division of the adjacency matrix. In examples of the method as discussed below in detail, the method may present a tree-like data structure in which intermediate nodes of the tree may be seen as a 2 dimensional fixed size array. This array may comprise a value to identify respective leaves.

Such a method provides an improved solution in storing an RDF graph database firstly by the obtention of obtaining one or more adjacency matrices representing the tuples of the database. Specifically, the tuples may be triples as each adjacency matrix may represent only one graph. Such an obtention of the one or more adjacency matrices constitutes a vertical partitioning of said database. As known *per se* an adjacency matrix is a binary matrix (i.e., a matrix with elements with two values, e.g., 0 and 1) of a size related to the number of subjects, predicates, and/or objects, which 1-bits mean that the corresponding triple (e.g., of a respective predicate for the adjacency matrix) exists in the RDF dataset. The size of the adjacency matrix for a predicate may be the size of subjects times by objects of RDF tuples for said predicate. The method, secondly, provides an improved solution by storing each of said one or more adjacency matrices as a data structure comprising an array of one or more indices where each index points to a sub-division of the adjacency matrix, and/or one or more elements each representing a group of tuples of the RDF graph database of a respective sub-division of the adjacency matrix. Such an array enables the method to store data related to one or more sub-divisions of each adjacency matrix. Thereby, the method improves storing RDF graph data in a graph database by storing a data structure in said database which efficiently compresses adjacency matrices. By "storing RDF graphs data in a graph database" it is meant storing data modelized as RDF graph(s) (i.e., an RDF dataset) in a graph database. RDF graphs may be one or more graph of data which represent/model respective data. Databases and RDFs are further explained hereinbelow. On the other hand, the method provides such a capability while allowing a dynamic (i.e., where read/write operations are possible on the stored database) in contrast to methods which are merely designed for a static, i.e., read-only memories.

In examples where the method presents a tree-like data structure, as discussed above, each intermediate node may be a 2-dimensional fixed size array. Such fixed size 2D arrays respective to the intermediate nodes may form at least partially said array comprised in the data structure. More specifically, such fixed size 2D arrays may comprise one or more indices each pointing to a sub-division of the adjacency matrix. By "database" it is meant any collection of data (i.e., information) organized for search and retrieval (e.g., a graph-oriented database). As known in the art, a graph-oriented database, is an object-oriented database using graph theory, therefore with nodes and arcs, allowing data to be represented and stored. The graph relates the data items in the store to a collection of nodes and edges, the edges representing the relationships between the nodes. The relationships allow data in the store to be linked together directly and, in many cases, retrieved with one operation. Graph databases hold the relationships between data as a priority; contrarily to other database models (e.g., relational databases) that link the data by implicit connections. When stored on a memory (e.g., a persistent memory), the graph database allows a rapid search and retrieval by a computer. Especially, graph databases are structured to for fast retrieval, modification, and deletion of relationships in conjunction with various data-processing operations. Graph-oriented database are also referred to as graph database; the expressions "graph-oriented database" and "graph database" are synonymous.

In examples, the graph database may be an RDF graph database. RDF graphs are a traditional data model used for the storage and the retrieving of graphs. RDF graph is a directed, labeled graph data format. Such format is widely used for representing information in the Web. A standard specification has been published by W3C to specify RDF representation of information as graphs, see for example "RDF 1.1 Concepts and Abstract Syntax", W3C Recommendation 25 February 2014 (or additionally the draft version RDF-star). An RDF graph database may have billions of tuples; for example the Uniprot dataset is a resource of protein sequence and functional information.

The core structure of the abstract syntax used is a set of tuples, each comprising a predicate. A set of such RDF tuples is called an RDF graph.

In examples, an RDF tuple may comprise three or four elements comprising nodes and edges. In examples, each RDF tuple (or elements of each RDF tuple) may be a triple comprising a subject, a predicate, and an object. In such examples, an RDF graph may be visualized as a node and a directed-arc diagram, in which each triple is represented as a node-arc-node link. Alternatively, an RDF triple may be visualized by two nodes, which are the subject and the object and an arc connecting them, which is the predicate.

In examples, the RDF tuple may be an RDF quad. An RDF quad may be obtained by adding a graph label to an RDF triple. In such examples, an RDF tuple includes the RDF graph. A standard specification has been published by W3C to specify RDF Quads (also referred to as N-Quads), see for example "RDF 1.1 N-Quads, A line-based syntax for RDF datasets", W3C Recommendation 25 February 2014. An RDF quad may be obtained by adding a graph name to an RDF triple. A graph name may be either empty (i.e., for a default or unnamed graph) or an IRI (i.e., a graph IRI. In examples, a predicate of the graph may have a same IRI as the graph IRI. The graph name of each quad is the graph that the quad is part of in a respective RDF dataset. An RDF dataset, as known *per* se (e.g., see https://www.w3.org/TR/rdf-sparql-query/#rdfDataset) represents a collection of graphs. Hereinafter, the term RDF tuple (or tuple) indifferently refers to an RDF triple or an RDF quad, unless the use of one or the other is explicitly mentioned.

Possible optimizations for a query engine of a graph database are impacted by the assumption that the graph database is interacting with an Open World or a Closed World. As known per se, in a formal system of logic used for knowledge representation, the open-world assumption (OWA) is the assumption that the truth value of a statement may be true irrespective of whether or not it is known to be true. It is the opposite of the closed-world assumption, which holds that any statement that is true is also known to be true. On the other hand, Closed World Systems require a place to put everything (e.g., slot on a frame, field on an OO class, or column in a DB). OWA assumes incomplete information by default which intentionally underspecifies and allows others to reuse and extend. Semantic Web is a vision of a computer-understandable web which is distributed knowledge and data in a reusable form and RDF, the W3C recommendation for the Semantic Web, follows the Open World Assumption. It allows a greater flexibility in data modeling and data storage. Yet the constraints of a Closed World Assumption, as in the relational model with SQL, are useful for query optimizations since they provide more information on how the data is stored. In examples, the query is a SPARQL query. SPARQL is the W3C recommendation for querying RDF data and is a graph-matching language built on top of patterns of RDF tuples. By a "pattern of RDF tuples" it is meant a pattern/template formed by an RDF graph. In other words, a pattern of RDF tuples is an RDF graph (i.e., a set of RDF triples) where subject, predicate, object, or label of the graph can be replaced by a variable (for a query). SPARQL is a query language for RDF data able to express queries across diverse data sources, whether the data is stored natively as RDF or viewed as RDF via middleware. SPARQL is mainly based on graph homomorphism. A graph homomorphism is a mapping between two graphs that respects their structure. More concretely, it is a function between the vertex sets of two graphs that maps adjacent vertices to adjacent vertices.

SPARQL contains capabilities for querying required and optional graph patterns along with their conjunctions and disjunctions. SPARQL also supports aggregation, subqueries, negation, creating values by expressions, extensible value testing, and constraining queries by source RDF graph. This means SPARQL queries needs to answer to eight different triple patterns possible in the SPARQL. Such eight triple patterns include (S,P,O), (S,?P,O), (S,P,?O), (S,?P,?O), (?S,P,O), (?S,?P,O), (?S,P,?O), and (?S,?P,?O) in which variables are preceded in the pattern, by the symbol ?. Variables are the output of triple patterns and may be the output of the SPARQL query. In some examples, variables may be the output of a SELECT query. The output of a SPARQL query may be built using the variables (e.g., aggregators like summation). Variables in a query may be used to build a graph homomorphism (i.e., intermediary nodes necessary to get the result of the query). In some examples, variables in a query may be neither used for output nor intermediary result. A Basic Graph Pattern (BGP) may be one of the eight triple patterns explained above. Additionally, a BGP may be a quad pattern with additionally having the label of the graph as the query variable. In particular examples where the method obtains one or more adjacency matrices each as representations of groups of tuples, subject and object may be queried on one adjacency matrix. In other words, in these particular examples, the BGPs may be any of (S,O), (S,?O), (?S,O), and (?S,?O). SPARQL may build more complex queries by joining the result of several BGPs and possibly other operators. Thus, competitive SPARQL engines require, at least, fast triple pattern solution and efficient join methods. Additionally, query optimizers are required to build efficient execution plans that minimize the number of intermediate results to be joined in the BGP.

In examples, the graph database has an existing triple store. A triple store (also referred to as RDF store) is a purpose-built database for the storage and retrieval of triples through semantic queries, as known in the art. A triple store can at least answer to the eight basic triple patterns of SPARQL described above. It may also answer to filtering constraints (e.g. "x > 5") along with the triples pattern. Such a triple store is considered to be the storage engine on which a SPARQL query is executed by a query engine. A storage engine (also called "database engine") is an underlying software component that a database management system (DBMS) uses to Create, Read, Update and Delete (CRUD) data from a database, as known in the art.

Back to FIG. 1, in step S10, the method comprises obtaining one or more adjacency matrices, each adjacency matrix representing a group of tuples of the graph database comprising a same predicate. In examples, the obtaining one or more adjacency matrices comprises performing a vertical partitioning for each predicate of the graph database. The method may perform the vertical partitioning as known in the field for example as described in document Abadi, D.J., et al., "Scalable semantic web data management using vertical partitioning.", In Proceedings of the 33rd international conference on Very large databases, September 2007, pp. 411-422. The step of the obtaining one or more adjacency matrices by performing the vertical partitioning may comprise obtaining a graph database and performing the vertical partitioning on the obtained graph database. By "obtaining a graph database" it is meant providing the database to the method. In examples, such an obtaining or providing may mean or comprise either downloading said database (e.g., from an online database, or an online cloud), or retrieving the database from a memory (e.g., a persistent memory).

In step S20, the method storing, for each of the one or more adjacency matrices, a data structure comprising an array. In examples, said array of the stored data is a 2D array of size $2" \times 2^n$ or a 1D array of size $2^{2n}$, n being a positive integer. In particular examples, the value of n may be equal to 2. This choice of n makes nodes of a size relatively small that can be easily aligned to the cache line size of modern processors, thereby improving the application of the data structure to be fit into the cache line. Furthermore, such a choice provides algorithms (like Test, Set, Reset, etc. as discussed below) to have a complexity of log16 rather than log4 complexity which is the case for n= 1.

In examples, the storing the data structure may comprise allocating a slot thereby obtaining a root index. Said root index represents a location of the tree data structure in a memory. The storing may further comprise setting the array at the root index to an array of coordinate pairs. In other words, and according to these examples, an empty data structure may be created (e.g., in a memory) with an empty root node of type V32 (which is explained below), while the location of this first node is represented by the "root index" so to enable the method to locate this first node in memory.

As discussed above, the stored array comprises one or more indices each pointing to a sub-division of the adjacency matrix, and/or one or more elements each representing a group of tuples of the RDF graph database of a respective sub-division of the adjacency matrix. In other words, the stored array may store indices which define a relative location of a sub-division of each adjacency matrix and/or a direct representation of a group of tuples of the RDF graph database of a respective sub-division of the adjacency matrix. In examples, each of the one or more indices may be of 32-bit size. In such examples, and when the value of the positive integer n discussed above is equal to 2, the stored array is of a maximal size of $2" \times 2^n \times 32bit$ = 64 bytes. Such stored arrayed may be equivalently called in a tree-like structure which is discussed below.

In examples, the stored database according to the method may represent a tree-like data structure configured to represent each adjacency matrix. In such examples, the data structure may comprise one or more nodes where each node being connected to one or more nodes and/or one or more leaves. The tree-like data structure may be (similar to) a quadtree data structure. A quadtree is a tree data structure in which each internal node has exactly four children. Quadtrees are the two-dimensional analog of octrees and are most often used to partition a two-dimensional space by recursively subdividing it into four quadrants or regions (see https://en.wikipedia.org/wiki/Quadtree).

In examples, the method may further comprise implementing one or more of the following functions on the RDF graph database. Each of the following functions may be configured to apply on each adjacency matrix of the one or more adjacency matrices: a function (called "Test" function) which is configured to check if a given cell of the adjacency matrix is set to a first specified value, a function (called "Set" function) which is configured to set a given cell of the adjacency matrix to a first specified value, a function (called "Reset" function) which is configured to set a given cell of the adjacency matrix to a second specified value, a function (called "ScanAll" function) which configured to output respective coordinates of all cells of the adjacency matrix with a first specified value, a function (called "ScanRow" function) which is configured to output respective coordinates of cells of a given row in the adjacency matrix with a first specified value, and/or a function (called "ScanColumn" function) which is configured to output respective coordinates of cells of a given column in the adjacency matrix with a first specified value.

In examples, each of the one or more elements of the array comprises a set of one or more coordinate pairs wherein each pair represents respective coordinates in the adjacency matrix. Such a representation of the respective coordinates in the adjacency matrix may be a direct representation of said coordinates (e.g., in V32 subtype) or an indirect representation of said coordinates (e.g., in V16 and V8 using a base and an offset with respect for said base).

Examples of memory layouts of an element discussed above are now discussed. By a "memory layout" or a "layout" it is meant an organized manner in which data are stored in a memory or in a file. As discussed herein below, each example (or kind) of memory layout may use indices of different size from another example of memory layout, for example indices of 32, 16, or 8bits. Each index may be associated to one coordinate in a pair of coordinates. In examples where the stored data structure represents a tree data structure (e.g., a quadtree data structure) each kind of memory layout may represent a kind of leaf node in said tree. Integrating different memory layouts (each with a different index size) in the stored database constitutes an improved solution for storing graph data in a graph database by adapting the stored data structure (or equivalently a leaf node of a corresponding tree) to a volume (i.e., size) of inserted data and therefore keeping good query time without sacrificing space efficiency. The method may set an ordering for storing the data structure according to an order, e.g., an optimized insertion order based on the Morton order (or Morton code/encode) as known in the field. Insertion (i.e., the insertion of subject, and object) according to the Morton encoding minimizes the number of modifications of intermediate nodes

In examples, an element of the one or more elements comprises a data structure of 32-bit indices with a layout, called V32 layout. Each 32-bit index is of a size of 32 bits. The size may be equivalently referred to as width, or bitfield width herein. By "a data structure of 32-bit indices" it is meant a data structure comprising a vector/array of a plurality of 32-bit integers each serving as an index. The V32 layout may in particular comprise one or more pairs of coordinates comprising a row and a column of the adjacency matrix. In such cases, each of the 32-bit indices is a coordinate in a pair of coordinates, i.e., an index represents a row or a column of the adjacency matrix. In yet other words, each row index is of size of 32 bits, and each column index is of size of 32 bits.

The V32 layout may be further defined by a fixed maximal capacity which indicates the maximum size of the data structure or equivalently the number of integers of the plurality. In examples, the size of layout may be smaller than the size of the stored one or more indices (i.e., the size of the intermediate node), for example in form of an (1D/2D) array as discussed above.

In some examples, the V32 layout may comprise a tag representing the size, and/or the maximal size (corresponding to the fixed maximal size) of the data structure (i.e., the vector representing the data structure). The tag may further represent a type of the data structure (i.e., a V32 type). Alternatively, the method may determine the tag corresponding to the element. For example, in a tree-like structure the method may determine said tag based on the respective depth of a respective node to the element in the tree. Such alternatives constitutes even more improved solution by freeing the size assigned to store the tag in the V32 layout (e.g., in a header), thereby increasing the maximal capacity the layout which is equivalent to optimizing the required storage.

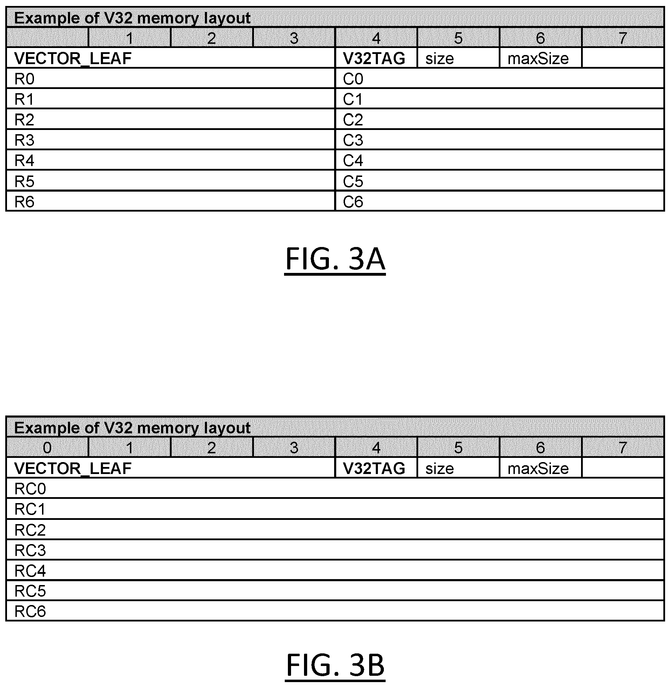

In examples of V32 data structure which is discussed below in reference to FIG. 3A and Fig. 3B, the size of the stored array is 64 bytes, and the memory layout reserves 8 bytes for metadata stored in the first row (i.e., VECTOR_LEAF, V32TAG, size, maxSize). Thereby the memory layout may store up to 7 pair of coordinates each pair being of 64 bits.

In examples, an element of the one or more elements comprises a data structure of 16-bit indices size with a layout, called V16 layout. Each 16-bit index may is of a size of 16 bits. As discussed above, by "a data structure of 16-bit indices" it is meant a data structure comprising a vector/array of a plurality of 16-bit integers each serving as an index. The V16 layout may in particular comprise one or more pairs of coordinates comprising a base column, a base row, an offset column, and an offset row of the adjacency matrix. In such cases, each of the 16-bit indices represents one coordinate in a pair of coordinates, i.e., represents a base column, a base row, an offset column, or an offset row of the adjacency matrix. In yet other words, each of the base column index, the base row index, the offset column index, and the offset row index is of size of 16 bits.

The V16 layout may be further defined by a fixed maximal capacity which indicates the maximum size of the data structure or equivalently the number of integers of the plurality. The maximal capacity of V16 layout may be same as the maximal capacity of V32 layout as discussed above.

In some examples, the V16 layout may comprise a tag representing the size and/or the maximal size (corresponding to the fixed maximal size) of the data structure. The tag may further represent a type of the data structure (i.e., a V16 type). Alternatively, the method may determine the tag corresponding to the element. For example, in a tree-like structure the method may determine said tag based on the respective depth of a respective node to the element in the tree. Such alternative constitute improved solutions as discussed for V32 above.

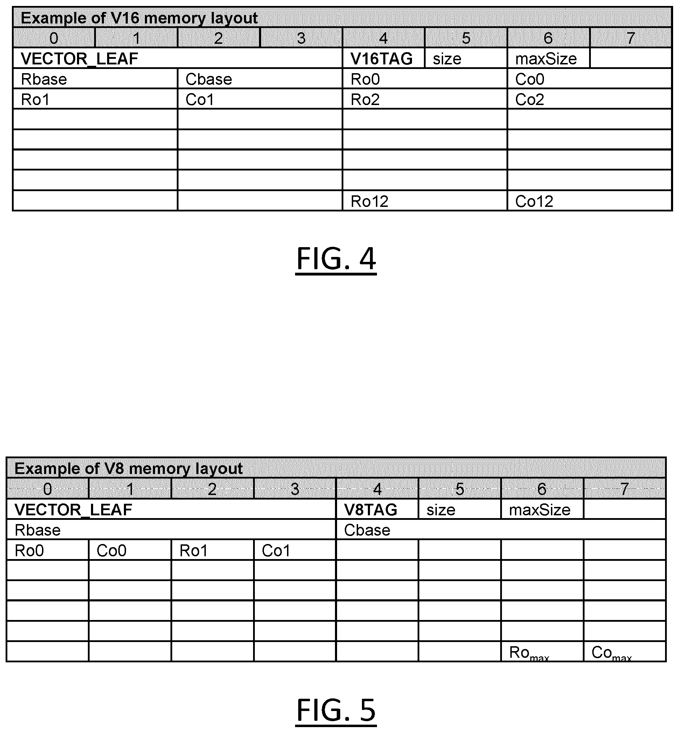

In examples of V16 data structure which is discussed below in reference to FIG. 4, the memory layout may store up to 24 pair of coordinates and/or respective value of pair of coordinates may be constrained in a translated submatrix of $2^8 \times 2^8$ size. memory layout may store up to 13 pair of coordinates and/or respective value of pair of coordinates may be constrained in a translated submatrix of $2^{16} \times 2^{16}$ size. In other words, in this case of the translated submatrix the coordinate pair $r_n, c_n$ is computed as (Rbase*2^16) + $Ro_n$, (Cbase*2^16)+$Co_n$. Here $Ro_n$ and $Co_n$ are constrained to 16 bits, i.e., $Ro_n$ and $Co_n$ are between 0 and $2^{16}$-1. Moreover, the submatrix translation is $2^x$ aligned.

In examples, an element of the one or more elements comprises a data structure of 8-bit indices with a layout, called V8 layout. Each 8-bit index is of a size of 8 bits. As discussed above, by "a data structure 8-bit indices" it is meant a data structure comprising a vector/array of a plurality of 8-bit integers each serving as an index. The V8 layout may in particular comprise one or more pairs of coordinates comprising a base column, a base row, an offset column, and an offset row of the adjacency matrix. For each leaf of a V8 layout there is one base row, one base column, and one or more offset row, and offset column pairs. In such cases, each of the 8-bit indices represents one coordinate in a pair of coordinates, i.e., represents a base column, a base row, an offset column, or an offset row of the adjacency matrix an index. In yet other words, each of the base column index, the base row index, the offset column index, and the offset row index is of size of 8 bits.

The V8 layout may be further defined by a fixed maximal capacity which indicates the maximum size of the data structure or equivalently the number of integers of the plurality. The maximal capacity of V8 layout may be same as the maximal capacity of V32 and V16 layouts as discussed above.

In some examples, the V8 layout may comprise a tag representing the size and/or the maximal size (corresponding to the fixed maximal size) of the data structure. The tag may further represent a type of the data structure (i.e., a V8 type). Alternatively, the method may determine the tag corresponding to the element. For example, in a tree-like structure the method may determine said tag based on the respective depth of a respective node to the element in the tree. Such alternative constitute improved solutions as discussed for V32 and V16 above.

In examples of V8 data structure which is discussed below in reference to FIG. 5, The V8 layout comprises a tag representing the size of the data structure, and one or more pairs of coordinates comprising a base column, a base row, an offset column, and an offset row of the adjacency matrix. For each leaf of a V8 layout there is one base row, one base column, and one or more offset row, and offset column pairs. As described for V16 case, for V8, respective value of pair of coordinates may be constrained in a translated submatrix of $2^8 \times 2^8$ size.

Specifically, V32, V16, and V8 layouts may be considered as variations of a same pattern with a same maximal capacity, i.e., V<nn > where nn is 32, 16, or 8. The parameter nn may be also presented simply as m. Other values of nn other than 32, 16, and 8 may be used. V<nn> is a vector of coordinate, where one or more coordinate offsets are stored using nn bits and a base coordinate is stored using 32 - nn bits. The 32 bits coordinates are extracted by combining the base and an offset (i.e., according to a bitwise operation (base << nn) | offset). In examples of an V<nn> layout, given a row column pair (each 32 bits index), the lowest nn bits of the row and the column are stored as offset, while the upper bits of the row and the column are shared (i.e., base). In the case of V32 layout, there is no need to store the upper bits because there is 0 bits to share.

In examples for a general V<nn> type, where nn is the bits of indices stored in the data structure, said data structure may further comprise a tag representing the size, the maximal size, and/or a type of the data structure (i.e., a V<nn> type or the value of nn) same to examples of V32, V16, and V8 discussed above. Alternatively, the method may determine said tag corresponding to the element. In examples (which are applicable to any of V32, V16, and V8 discussed above), the determining of the tag may be based on the pair of coordinates. In examples, the method may determine the tag by the size of the translated submatrix that can be held by the node and/or the number of pairs of coordinate that is to be stored in the node. For example, in a tree-like structure the method may determine said tag based on the respective depth of a respective node to the element in the tree (which may be related to the translated submatrix and/or the number of pairs of coordinate to be stored mentioned above). As discussed above, such alternatives constitutes even more improved solution by freeing the size assigned to store the tag (e.g., in a header), thereby increasing the maximal capacity of the layout which is equivalent to optimizing the required storage.

In examples, which are combinable with any of the examples discussed above, the stored data structure may further comprise a bit array of bitmap representation of a group of RDF tuples in a respective sub-division of the adjacency matrix. As known *per se* by a "bitmap" it is meant a mapping from one system such as integers to bits. It is also known as bitmap index or a bit array. This constitutes an improves solution as bitmap representation forms a representation of the one or more elements with smaller size. Thus, the examples of the method comprising the bit array further optimize the memory cost.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

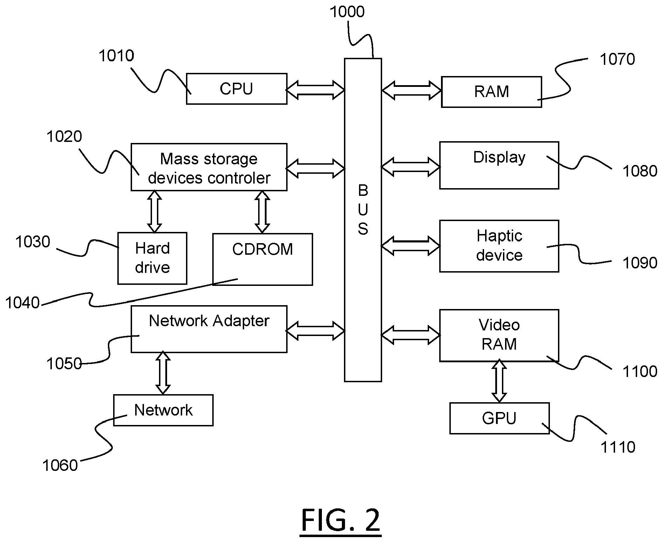

FIG. 2 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

Implementations of the hereinabove discussed examples of the method are now discussed.

The implementations are related to RDF database which needs to be able to handle very large datasets. RDF is the W3C standard to represent knowledge graphs. Knowledge graphs can have billions of triples (e.g. MAG, Uniprot). The explosion in the amount of the available RDF data and consequently the size of graph databases justify a need to explore, query and understand such data sources.

Reducing the storage size of such graphs (in memory or on a disk) is important to reduce cost and environmental footprint in cloud deployment. That is why data compression (https://en.wikipedia.org/wiki/Data compression) and more precisely, compression of graphs (i.e., compression of graphs data represented by RDF triples) is a key concept in exploiting the implementations.

The implementations involve using vertical partitioning to represent a graph. Using this scheme to represent RDF graphs leads to a representation where each predicate is itself a graph where subjects and objects are the nodes and the predicate the edges. These graphs can then be seen as n adjacency matrices. Therefore, compressing graphs means using a data structure to efficiently compressed adjacency matrices. In this direction, the implementations further involve dictionary encoding (https://en.wikipedia.org/wiki/Dictionary_coder) where input values are encoded into integer keys as a first step to data compression. This means that the adjacency matrices manipulate integers instead of strings.

The implementations are specifically related to the field of data structures used to represent adjacency matrices of integers with the objective of compressing very big RDF graphs. This takes place in the field of space-efficient graph representations. In the implementations, the graph (i.e., the graph database) may be in particular dynamic which means that it can be modified and is not read-only. The stored database according to the implementations may be queried without decompressing the data stored in the database.

More specifically, the implementations provide a space-efficient representation of dynamic RDF graphs, represented as adjacency matrices of integers that scales to very large matrices. This means that the elapse time for traversal on as such stored graph databases does not deteriorate and that the representation is still space-efficient (compared to read-optimized data structures).

The implementations in particular discloses a data structure called XAMTree which takes place in the general field of quad-tree data structures (in the sense that it partitions a two dimensional space by subdividing it into four quadrants) and share some traits of Patricia Tries (https://en.wikipedia.org/wiki/Radix_tree#PATRICIA), like K2-Tree as described in the article ÁLVAREZ-GARCÍA, S., et al., "Compressed vertical partitioning for efficient RDF management.", Knowledge and Information Systems, 2015, vol. 44, no 2, p. 439-474. Quad-tree is interesting for efficient spatial search, and Patricia trees are interesting for the variability of their internal nodes.

A XAMTree according to the implementations is constituted of nodes which fan-out across the two dimensions of an adjacency matrix (row and column). Each node is constituted of $2^n \times 2^n$ cells and consumes n bits across the two axis. The implementations provide several kinds of leaf nodes for a XAMTree, and an optimized structure of the tree in exploiting each kind according to the volume of inserted data. Therefore the implementations provide good query time without sacrificing space efficiency. Such an optimized insertion order (i.e., the order according to which each kind of leaf node should be used) is according to Morton order (https://en.wikipedia.org/wiki/Z-order curve).The implementations also take advantage of novel CPU instructions called AVX in relational query engines as for example described in KERSTEN, T., et al., "Everything you always wanted to know about compiled and vectorized queries but were afraid to ask.", Proceedings of the VLDB Endowment, 2018, vol. 11, no 13, p. 2209-2222. This further improves the query elapse time in the implementations.

The data structure according to the implementation is organized in such a way that it limits the number of memory area modified by a write and respects the cache lines (to avoid cache misses). Furthermore, the XAMTree has an optimized insertion order (i.e., a Morton encoding) and rebuilding a XAMTree in its ideal optimized state is straightforward. Contrary to the dynamic K2Tree, the algorithmic complexities for a XAMTree have an upper bound of space usage at worst $O(n \log_m n)$ where n is the number of bit set in the adjacency matrix and the order of insertions does not penalize the XAMTree compared to the dynamic K2. While basic access methods have the same worst case of algorithmic complexities as a static K2Tree, the topology of the adjacency matrix further improves performance of a XAMTree data structure, as XAMTree is not a balanced tree. Additionally, XAMTree is less sensitive to the topology of the adjacency matrix than a dynamic K2Tree (DK2).

According to the implementations, a XAMTRee is a data structure mixing a tree similar to a QuadTree, and leaves storing coordinate pairs vectors and leaves representing a bitmap. As known (e.g., from Wikipedia (https://en.wikipedia.org/wiki/Quadtree) a QuadTree is a tree data structure in which each internal node has exactly four children. Quadtrees are most often used to partition a two-dimensional space by recursively subdividing it into four quadrants or regions. The data associated with a leaf cell varies by application, but the leaf cell represents a "unit of interesting spatial information".

The implementations implement an adjacency matrix answering to the following functions which are the requirement to use it to represent RDF graphs' data.

When "r,c" are the coordinates of an adjacency matrix represented by the QuadTree, setting a bit means the corresponding cell of the matrix has a value of "true" (and resetting a value of "false"):

- set(r,c) set bit at r,c coordinate to true
- reset(r,c) reset bit at r,c coordinate to false
- test(r,c) → Boolean return the state of bit at r,c coordinate
- observers which, as known *per se,* enable notification of any state changes. Such observers may be implemented as iterators (see https://en.wikipedia.org/wiki/Iterator) or visitors see https://en.wikipedia.org/wiki/Visitor_pattern). Examples of observers may be as follows:

    ◦ scanRow(r) → {c} which returns the set of c where test(r,c) is true. scanRow may also return a r,c set where r is an invariant.
    ◦ scanColumn(c) → {r} which returns the set of r where test(r,c) is true. scanColumn may also return a r,c set where c is an invariant.
    ◦ scanAll() → {r,c} which returns the set of r,c where test(r,c) is true.

*Bitwise operation used in the following algorithm*

The implementations further include several bitwise operations on an unsigned integer as listed in the following Table 1.

*Table 1*

| Operation | Description |
|---|---|
|  |  |

| | |
|---|---|
| a & b , a \| b and ~a | Bitwise and, or and not. Such as defined in various language like c, c++ or java...supported by all modern processor |
| m << n | Arithmetic shift left (ASL) which compute m $*$ $2^n$. Usually supported by all modern processor. |
| m >>> n | Zero-fill arithmetic shift right (ASR) which compute m $/$ $2^n$. Usually supported by all modern processor. We use the >>> java/javascript to remove any ambiguities. |
| ROL(m,n) | bitwise left rotation of m repeated n time, https://en.cppreference.com/w/cpp/numeric/rotl<br>This function can be either emulated or a processor intrinsic such as the rol instruction for x86/x64 processor |
| ROR(m,n) | bitwise right rotation of m repeated n time |
| Mask(m,n) | reset all bit above a specified bit number n and leave the n lowest bit unchanged.<br>Return (m & (( 1 << n )-1) |
| CopyLowestBits(base, offset, b) | Return a copy of base where the b lowest bits have been replaced by the b lowest bits of offset<br>return ((base & ~ ( (1<< b) -1)) \| (offset & (1<< b) -1)) |
| PartialEncode(m,n) | A helper function that perform a partial "Morton encoding" of m. by extracting n consecutive bits of m then n bits at 0...<br>b = 0 ; $m_i$ → $b_{i\%n + 2n(i/n)}$ ; return b<br>This function can be either emulated or a processor intrinsic such as the pdep instruction for x86/x64 processor can be used, .<br>Example:<br>PartialEncode(m,1) ó pdep32(m,0x55555555), if m is a 32 bits integer and n=1<br>PartialEncode(m,2) ó pdep32(m,0x33333333), if m is a 32 bits integer and n=2 |

| PartialDecode(m,n) | Is the inverse function of PartialEncode(m,n)<br><br>This function can be either emulated or a processor intrinsic such as the pext instruction for x86/x64 processor can be used.<br><br>Example:<br><br>PartialDecode(m,1) ó pext32(m,0x55555555), if m is a 32 bits integer and n=1<br><br>PartialDecode(m,2) ó pext32(m,0x33333333), if m is a 32 bits integer and n=2 |
|---|---|
| Popcount(a) | Compute the bit population count of integer a<br><br>https://en.cppreference.com/w/cpp/numeric/popcount.<br><br>This function can be emulated or a processor intrinsic such as popcnt for the x86/x64 processor can be used |

*Description of the elements of a XAMTree*

A XAMTree is a tree data structure composed of three kinds of nodes: intermediate (i.e., non-terminal) nodes, vector leaves or leaves with a vector of coordinates, and bitmap leaves or leaves with bitmap. Each of the three nodes is discussed hereinbelow.

Intermediate nodes (TN)

An intermediate node TN of a XAMTree is made of a 2d array of indices of size $2^n \times 2^n$ pointing to optional sub-elements. Each slot of this array may specify a sub item. $n$ must be a strictly positive integer. A TN may be represented a 1d array of size $2^{2n}$ where the row and column relative to a TN can be encoded using $((row *2^n) + column)$ or $((column *2^n) + row)$ convention. The implementations exploit a 1d array representation and encode the representation as $((row *2^n) + column)$.

Hereinbelow, n is a constant and be referred to as $\delta$. Furthermore, the implementations use two constants, TNWIDTH as a shortcut for $2^\delta$ (or equivalently as a bitwise left shift operator $1 << \delta$) and TNSIZE as a shortcut of TNWIDTH$^2$ or $2^{2\delta}$.

The implementations set $\delta=2$. Such a value is an optimized value as it makes the nodes of the XAMTree of a size relatively small that can be easily aligned to the cache line size of modern processor and while resulting in algorithms with a complexity in $\log_{16}$ rather than $\log_4$ for $\delta=1$. In variations, the implementations may set other values for $\delta$.

The implementations set 32 bits indices for a TN to have nodes with a limited size of 64 bytes (512 bits = $2^2 \times 2^2 \times 32$) while still being able to create adjacency matrices with several billions of bits. In variations, the implementations may use 64 bits indices which however leads to increased storage.

By convention, the implementations set the index to 0 in order to specify an unallocated node, meaning to indicate that there are no more sub element of the adjacency matrix with cells valued to "true" when we split the matrix (as known in the field for example from the already cited document ÁLVAREZ-GARCÍA, S., et al., "Compressed vertical partitioning for efficient RDF management.", Knowledge and Information Systems, 2015, vol. 44, no 2, p. 439-474). In variations, the implementations may set other values than 0 as the index value to specify unallocated node. Hereinbelow, said value (either being 0 or other variations) is referred to as UNALLOCATED_NODE.

Leaves with a vector of coordinates (Vnn)

A vector leaf Vnn is an element of a XAMTree with the exact same size as an intermediate node TN described above. The implementations identify each Vnn leave with an integer of a specific value at the beginning of the structure of the corresponding element of the Vnn leave in the XAMTree. For example, the implementations may be set to identify Vnn leaves with a 32 bits integer of value 0xffffffff at the beginning of the corresponding structure of each Vnn leave in XAMTree. In variations, the implementations may set to other arbitrary values. Hereinbelow, said arbitrary index value is referred to as VECTOR_LEAF. The implementations may set the value VECTOR_LEAF as an invalid index for the intermediate nodes TN.

Vector leaves are fixed maximal capacity adjacency matrices that fit into a tree node. In other words, Vnn leaves may store r,c, pairs up to said maximal capacity. The implementations may set different layout (i.e., a memory layout) for Vnn nodes. Each layout defines a subtype for vector leaves with a shared maximal capacity among the subtypes imposed by the fact that the implementations require a Vnn to have an equal or smaller size than a TN (i.e., being able to fit in the size of a TN).

The implementations define three subtypes as V32, V16, and V8 with a respective 32, 16 or 8 bit index size as (which in combination with a shared maximal size for all subtypes corresponds to a maximal capacity of r,c pairs to be stored in each subtype), and a current size (corresponding to the number of slots in-use). According to the implementations, each subtype may have a base pair r,c and/or a vector of variable length depending on the subtype (resp. 64 bits, 32 bits and 16 bits for each of V32, V16, and V8). The length refers to the number of used row-column coordinates in the data structure. Said length varies according to the type of V<nn> data structure. Theoretically said Length varied between 1 and the maximal length of a Vnn. In other words, for a 64 bytes Leaf node size, it is up to 7 for V32; up to 13 for V16; and up to 24 or 25 for V8 depending on the implementation. The base pair r,c (or explicitly rbase, cbase) is used to define each pair of coordinates for example in combination with an offset value (e.g., roffset,coffset) in the layout (e.g., using an operation comprising rbase+roffset,cbase+coffset).

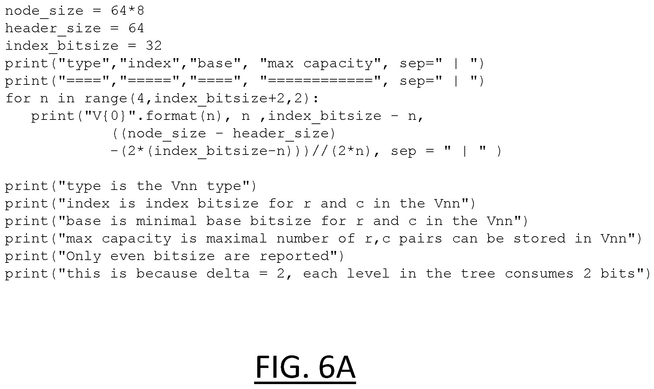

FIG. 6A presents a sample code in Python language to compute the length of the vector discussed above according to examples of the method for several Vnn data structures. In such examples, each leaf node is of the size of 64*8 bits (node_size), and the header is 64bits (header_size). Furthermore, the size of each intermediate nodes in 32bits (index_bitsize). As n (or delta) is set to 2 and each level in the tree consume 2 bits, only even bitsizes are reported.

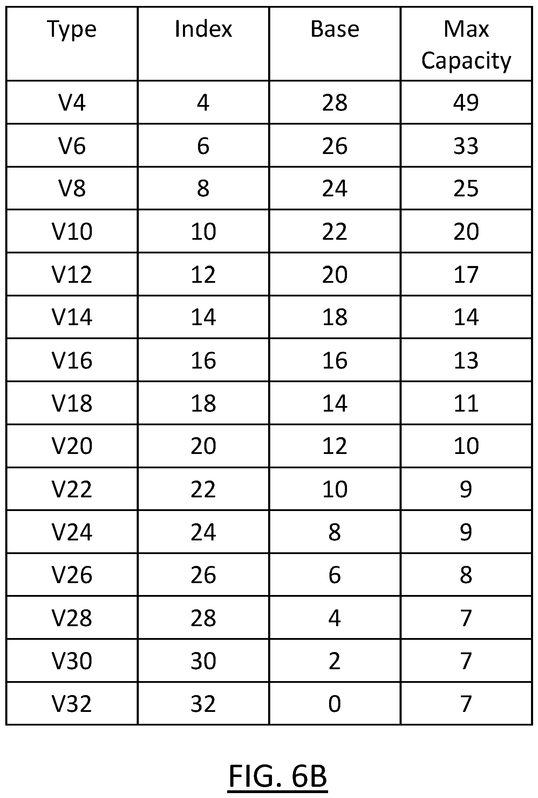

FIG. 6B presents a table of the results of the Python code for different types, i.e., Vnn type according to the value of nn. By "index" is meant index bitsize for r and c in the Vnn, "base" is the minimal base bitsize for r and c in the Vnn, and "max capacity" is the maximal number of r,c pair that can be stored in the Vnn.

According to the FIG.s 6A-6B, base value is calculated according to the formula index_bitsize - n, and the max capacity is computed according to the formula $((\text{node\_size} - \text{header\_size}) - (2*(\text{index\_bitsize}-n)))//(2*n)$. The results presented in FIG. 6B further imply a comparison between the maximum capacity of different index sizes can be realized. For example, V6 have the max capacity 32% larger than V8 and is a good candidate. Furthermore, V10 and V12 have the maximum capacity 54% and 30% larger than V16, respectively while V24 capacity is 28% more than V32. On the hand, V14 compared to V16, V20 and V22 compared to V24, and V26 compared to V24 and V32 are of low benefit in terms of larger capacity. Furthermore, V24 is an interesting format to minimize the number of intermediate node mandatory to insert a V16 node, and V12 for the same reason but respective to V8 node.

The determining of the tag as discussed above may in particular, at least partially, comprise calculations similar to FIG. 6A.

The implementation may use each of 32, 16 or 8 bits r,c according to the depth of the vector leaf. In other words, the deeper the VECTOR_LEAF is created there is fewer difference between 2 r,c pairs and therefore the implementations need fewer bits to represent this value. On the other hand, by using 8, 16 and 32 bits basic arithmetic the implementations keep extraction of the data simple and efficient.

Examples of memory layout of various coordinate vector leaves for $\delta$=2 and 32 bits index and a $2^{32} \times 2^{32}$ matrix are now discussed in reference to FIG.s 3A to 5.

FIG. 3A presents an 8x8 table which mimics the layout of 64 bytes data structure (V32) of 8 rows of 8 bytes. The implementations may store up to 7 r,c pairs in the layout presented in FIG. 3A, and the extraction of each r,c is by reading the stored value in the layout.

FIG. 3B presents a variant of the V32 layout presented in FIG. 3A. According to this variance, the implementations use encode $\delta$(r,c) (which is described below) to encode r,c pair. In cases when these r,c pairs are ordered the implementations may maintain scan algorithm to behave like a K2Tree.

FIG. 4 presents an example of memory layout for V16. The implementations may store up to 13 r,c pairs in the layout presented in FIG. 4. The implementations may extract a pair of r,c $r_n$ = Rbase << 16 | $Ro_n$ and $c_n$ = Cbase << 16 | $Co_n$. According to this layout, r,c pairs values are constrained in a translated submatrix of $2^{16} \times 2^{16}$ size. In other words, the method may compute the pair r,c as $r_n$ = (Rbase $*2^{16}$) + $Ro_n$ and $c_n$ = (Cbase $*2^{16}$) + $Co_n$ where x << n is equivalent to x $*2^n$. Because all the lowest 16 bits are zeroed the bitwise OR operation can be replaced by addition. But the << operator (i.e., a bitwise left shift operator) and | operator (i.e., a bitwise OR operator) can be applied only to integer value, thereby better guiding a compiler for a correct optimization.

FIG. 5 presents an example of memory layout for V8. The implementations may store up to 24 r,c pairs in the layout presented in FIG. 5. The implementations may extract a pair by adding base value and offset. According to this layout, r,c pairs values are constrained in a translated submatrix of $2^8 \times 2^8$ size.

In variations of the implementations, Instead of one VECTOR_LEAF tag as discussed above, it is also possible to use a VECTOR_LEAVES range, and to encode the subtype and size in this range in order to increase V16 and V8 subtype capacity.

Leaves with bitmap (BL)

In the implementations, and after a certain depth in the tree (i.e., XAMTree), the storage cost of tree nodes or of vector leaves is greater than the cost of a bitmap representation of the data. The implementations may set a BLDEPTH value as a XAMTree depth where only BL can be found.

For example, when $\delta=2$ and the index is 32 bits a TN costs 64 bytes while the last two levels of the tree represent a submatrix of 16x16 bits. Thereby using bitmap leaves improves the storage size. The implementations may use a 256 bits bitmap that fit in 32 bytes to represent the 2 last level of the tree. In cases where there is less than a few bits set in this submatrix using a BL instead of a vector leaf, the implementations may reduce the memory cost by a factor of 2, but if the antepenultimate vector (i.e., the vector corresponding to the last levels of the tree) is saturated the implementations may create up to 16 leaves. The implementations allocate bitmap leaves not in the same way as TN and Vnn so the indices in the last TN does not point to the same thing as bitmap leaves. In particular, the implementation allocate the bitmap layer (i.e., the layers represented by bitmap) in a homogeneous way and without tagging. This The implementations exploit bitmap leaves as a safeguard preventing huge memory usage.

The implementations identify for each case of $\delta$ and width of the index, the depth at which the tree of TN includes only bitmaps. For example, when $\delta=2$ and the width of the index is 32 bits, each level of tree consumes $\delta$ bits, thereby BLDEPTH= indexbits - 2*$\delta$ is 32 - 2 - 2 = 28 bits. The implementations may represent the last level of a XAMTree as a bitmap. The implementations may alternatively define a bitmap for the two last level for $\delta=1$ or $\delta=2$ because the bitmap is smaller than a tree node. In variations where $\delta>2$, the implementations may only define bitmap laves for the last level of the XAMTree.

XAMTree structure

The implementations may construct a XAMTree by two arrays of fixed size elements as follows:

- an array of nodes and vector leaves, called NV, and
- an array of bitmap leaves, called BM.

The implementations may create and store the two arrays either in memory (a memory heap for instance) or in a file. In examples where the size of a bitmap element is the same as the nodes size the implementations may not create the BM array. The implementations may take into account other criteria not to perform the optimization by using BM.

The implementations may manage the access to NV and/or BM via the following functions summarized in Table 2.

*Table 2*

| Operation | Description |
|---|---|
| Allocate(array) → index | return the position of a free slot in the array, this allocator will avoid to return some value such as (UNALLOCATED_NODE and VECTOR_LEAF) |
| Deallocate(array, index) | tell the array that the array slot is free and can be reused |

| Get<type>(array, index) → type | return the requested tree node, vector leaf or bitmap at specified index |
|---|---|
| Set<type>(array, index, type) | set the specified array slot at index |

Hereinbelow the notation of array[index] present get and set operation in BM and NV. The implementations may set a header descriptor which contains the root index.

First, an updatable (i.e., dynamic) version of the XAMTree is presented and then a read-only version is detailed.

*Initialization*

The implementations may create an empty XAMTree according to the following steps:

1. Allocating a slot in NV array and store the returned index in root index.
2. Setting NV[root index] to an empty V32.

*Functions to implement*

The implementations comprise the following functions in order to be used to answer SPARQL queries on the stored database as Table 3.

*Table 3*

| Operation | Description |
|---|---|
| Test | check if a given cell is set to "true" in the adjacency matrix |
| Set | set the value of a given cell to "true" |
| Reset | set the value of a given cell to "false" |
| ScanAll | scan all the adjacency matrix to get the coordinates of all "true" in the matrix |
| ScanRow | scan a row to get the coordinates of all "true" in the row |
| ScanColumn | scan a column to get the coordinates of all "true" in the column |

The implementations further implement the following functions as listed in Table 4.

*Table 4*

| Operation | Description |
|---|---|
| encodeδ(r,c)→rc | Which return the partially encoded r,c pair: PartialEncode(r, δ) << δ \| PartialEncode(c, δ) |
| decodeRowδ(rc)→r | Row can be extracted PartialDecode(rc>>>δ,δ) |
| decodeColδ(rc)→c | PartialDecode(rc,δ) |

Details of the algorithm of the implementations for the above functions are now discussed.

*Algorithm for the Function "Test"*

Parameters: r, c a row and a column to check

**Initial** condition :

Let say cursor is root index
Let say RC = Encodeδ (r, c)
Let depth = 0

**Algorithm**

```
1. If cursor is UNALLOCATED_NODE then
   there is no node, nor any kind leaf there is no bit set for (r,c)
   test must return false
2. Else If depth is BLDEPTH then there is a valid bitmap
   check the bit in (r,c) in the bitmap at cursor in BM
   test returns with the result of the previous check
3. Else if NV[cursor][0] is VECTOR_LEAF then obtain a coordinates vector leaf
   test check the existence of the r,c pair using the proper algorithm according
   to the vector leaf subtype
   test returns the result of the previous check
4. Else obtain a tree node, move down the tree
   Set depth to depth + 2
   Let RC = rol(RC, 2δ)
   Let cell = mask(RC, 2δ)
   Set cursor to NV[cursor][cell]
 Restart at 1
```

*Algorithm for the Function "Set"*

Parameters: r, c a row and a column to set

**Initial condition :**

Let say cursor is root index

Let say RC = Encodeδ (r, c)
Let depth = 0

**Algorithm**

```
1. If cursor = UNALLOCATED_NODE then there is no node, nor any kind leaf this
   condition is not valid
2. Else If depth = BLDEPTH then there is a valid bitmap
     set the bit in (r,c) in the bitmap at cursor in BM
     return
3. Else if NV[cursor][0] = VECTOR_LEAF then
   obtain a coordinates vector leaf
   check the existence of the r,c pair using the proper algorithm according to the
   vector leaf subtype and if true return
   If NV[cursor] cannot insert the r,c pair:
        a. extract the current coordinate vector
        b. mutate the current coordinates vector subtype to another subtype
           that can accept the r,c pair.
        c. If b. fail mutate the current coordinates vector into a tree node and
           distribute the content into two or more sub leaf (either a VL or a BL)
           in the case of one sub leaf the distribution may fail, repeat c at a
           deeper level, this will eventually finish by a split in two or more VL or
           one or more BL sub leaf that can accept all the extracted current
           coordinate vector
   Else insert the r,c pair
5. Else
     There is a tree node, move down the tree
     Set depth to depth + 2
     Let RC = rol(RC, 2δ)
     Let cell = mask(RC, 2δ)
     Let next to NV[cursor][cell]
     if next is UNALLOCATED NODE then
     if depth = BLDEPTH then
         allocate a bitmap leaf into BM and set next to this value
     else
         allocate a coordinates vector leaf into NV and set next to this value
   Update NV[cursor][cell] to next
   Set cursor to next
   Restart at 1
```

The mutation in sub-step b. is what that makes the XAMTree asymmetric (i.e., with different subtypes throughout the tree) and prevents degenerations as seen in the K2-Tree. In other words, if there is a locality issue (e.g. values scattered on an area of the matrix, preventing the benefit of a sparse matrix) then only the nodes of this area are impacted thanks to this mutation (and not all the typology of the tree as in the K2Tree).

*Algorithm for the Function "Reset"*

Parameters: r, c a row and a column to reset

**Initial condition:**

Let say cursor is root index
Let say RC = Encodeδ (r, c)
Let depth = 0

**Algorithm**

```
1. If cursor = UNALLOCATED_NODE then
     There is no node, nor any kind leaf there is nothing to remove
   return
2. Else If depth = BLDEPTH then
  We have a valid bitmap
  reset the bit in (r,c) in the bitmap at cursor in BM
       return
3. Else if NV[cursor][0] = VECTOR_LEAF then
     There is a coordinates vector leaf
     check the existence of the r,c pair using the proper algorithm according to the
     vector leaf subtype and if false return
     If NV[cursor] cardinality is one it is possible
        a. Clear the vector leaf
        b. Deallocate the node and update the parent node if the cursor is not
            root index
   Else remove the r,c pair from NV[cursor] using the proper algorithm according
   to the vector leaf subtype
   return
6. Else
     We have a tree node, move down the tree
     Set depth to depth + 2
     Let RC = rol(RC, 2δ)
     Let cell = mask(RC, 2δ )
     Set cursor to NV[cursor][cell]
   Restart at 1
```

*ScanAll, ScanRow and ScanColumn generalities*

Non-recursive algorithms of scanAll, scanRow and scanColumn is now discussed. These algorithms use a fixed size stack.

These algorithms are efficient scan algorithms because the visitor version (https://en.wikipedia.org/wiki/Visitor pattern) does not need heap allocation (https://en.wikipedia.org/wiki/Memory management#HEAP), an abstract iterator (https://en.wikipedia.org/wiki/Iterator pattern) can be implemented in various language with only one heap allocation, and concrete iterator can be implemented without heap allocation. Therefore, the implementations may use a visitor or iterator pattern instead of a recursive algorithm to improve the heap allocation. As known in the field, despite the fact that all the presented iterator algorithms may be expressed recursively as long as there is a generator concept built into the programming language, it is rather difficult to write an iterator from a recursive algorithm without some means provided by the programming language. On the other hand, while obtaining a recursive visitor, or a visitor implemented from an iterator is trivial, the obtention of a recursive iterator without a generator concept is complex. In the implementations, the size of the stack object is fixed which allows to allocate it without dynamic allocation. This improves an implementation of an abstract iterator with at least one allocation. Furthermore, it is always possible to obtain a recursive version of this algorithm.

*Algorithm for the Function "ScanAll"*

According to the implementations, the algorithm iterates over all leaves of the XAMTree using a breadth first traversal of the internal node TN.

Let define a stack of ScanContext with the following data and operations:

**Data structure:**

ScanContext is a record, which contains a "current_node" index and a "position" in the current node. "current_node" is the index of the node or leaf in NV array or in BM array to be scanned. "position" index indicates the position to process if the current_node is a tree node. The index of "position" can be an integer or a pair of integer or deduced from baseRC (which is described below). A ScanContext record may also keep some other cache data such as pointer to NV[current_node ], in this case current_node may be optimized. Stack is a record, which contains:

1. A_data fixed size array of ScanContext. The array size must be greater than BLDEPTH / $\delta$. The implementations may an array of record but it is also possible to use several array for instance a _data_current_node array and a _data_position array.

2. A_top integer, which indicates the position in the stack. This field is initialized to 0, incremented on push and decremented on pop. A pointer can be used to perform the same feature. If _top is null the stack is empty.

3. a baseRC coordinate which is updated during the scan. Because $\delta$ is a power of 2, baseRow and baseColumn can be encoded using the Morton encoding or a partial Morton encoding, this can be useful to minimize the number of operation to manage those two data. baseRC can be replaced by two integer baseRow and baseColumn without changing this invention. baseRow (baseColum resp.) can be retrieved by computing decodeRow$\delta$ (baseRC) (decodeCol$\delta$(baseRC) resp.)

Stack operations are:

1. empty is true if _top is 0
2. pop will :
    a. drop the top of stack by decrementing _top by 1
    b. adjusting the baseRC pair
  set baseRC to the results of baseRC >>> (2$\delta$)
3. top returns_data[_top - 1]
4. is BLDepth return _top == BLDEPTH / $\delta$
5. push(integer cell)
    a. increment _top by 1
    b. set baseRC to the result of CopyLowestsBits(baseRC ,cell, 2$\delta$) << (2$\delta$)
6. nextAII
    a. let cur is top.current_node
    b. let cell is top.position
    c. skip in NV[cur] the next UNALLOCATED_NODE starting from cell, and update cell according
       repeat until break
         i. if cell >= TNSIZE then
            break
         ii. if UNALLOCATED_NODE != NV[cur][cell] then
            break
         iii. increment cell by 1
    d. if cell >= TNSIZE then
        pop()
    e. else
         i. let down index is NV[cur][cell]
         ii. update top.position to cell+1 for next call to next
         iii. update stack by pushing and updating position
            push (cell)
         iv. set top.position to 0
         v. update top.current_node to down index

**ScanAll Algorithm**

1. create a stack
2. push the root index into the stack
    a. push(0)
    b. update stack.top.current_node to root index
    c. update top.position to 0
3. While stack is not empty
    a. If stack isBLDepth then
        We have a bitmap leaf
         i. yield all coordinate from BM[stack top current_node] using stack baseRow, baseColumn
         ii. pop stack
    b. Else if NV[cursor][0] = VECTOR_LEAF then

```
We have a coordinate vector leaf
        i. yield all coordinate from NV[stack top current_node] (may use
           stack baseRow and baseColumn)
        ii. pop stack
    c. Else
        We have a tree node
            i. Compute next stack state by invoking nextAll
```

*Algorithm for the Function "ScanRow"*

In this algorithm, the input parameters are a row r to scan and the algorithm iterates over all leaves of the XAMTree using a breadth first traversal (https://en.wikipedia.org/wiki/Breadth-first search) of the internal node TN. This algorithm is a refinement of scanAll discussed above.

**Data structure:**

The implementations uses a stack similar to the stack used in scanAll and associate to the stack a _filterRC field. _filterRC is initialized by PartialEncode(r, $\delta$) << $\delta$. Specifically, _filterRC is initially set to Encode$\delta$(r, 0), then during the XAMTree scan the implementations perform logical rotate to the left (ROL) by 2$\delta$ when at the beginning of scanning of a node (TN) and a logical rotate to the right (ROR) by 2$\delta$ when the scan of a node is finished. As known *per se,* the bitwise operation ROL(n) performs the following bitwise operation to transform an source array of bits (Source) into a destination array of bits (Dest):

For I from 0 to w-1

$$Dest(i+n)\%w = Source(i)$$

where w is the number of bits in the source array which is also equal to the number of bits in the destination array. Thereby, through this chain of bitwise operations, the 2$\delta$ upper bits of an array become the 2$\delta$ lower bits of the array. Consequently, by masking the 2$\delta$ lower bits, i.e.,by an application of the _filterRC 2$\delta$, the lowest bit of the array contain the initial position to use. This helps the implementations to obtain an the start index in the TN to scan.

The implementations extend the Stack described in ScanAll with the following operations:

```
1. initFilter(r,c)
      a. set_filterRC = Encodeδ (r, c)
      b. pushFilter(0)
      c. update top.current_node to root index
      d. update top.position to mask(_filterRC, 2δ)
2. popFilter will :
      a. invoke pop
      b. set _filterRC to ror(_filterRC, 2δ)
3. pushFilter(integer cell)
      a. invoke push(cell)
      b. set _filterRC to rol(_filterRC, 2δ)
4. nextRow
   instead of scanning all cell of a TN scan only one row from, mask(_filterRC, 2δ)
   to mask(_filterRC, 2δ) + TNWIDTH excluded.
      a. let cur is top.current_node
      b. let cell is top.position
      c. Let end be mask(_filterRC, 2δ) + TNWIDTH.
         but also can be deduced from cell (cell |(TNWIDTH-1))+1 (The
         implementations prefer the latter form which does not require to load
         _filterRC).
      d. skip in NV[cur] the next UNALLOCATED_NODE starting from cell, and
         update cell according to the following steps:
         repeat until break
            i. if cell >= end then
               break
            ii. if UNALLOCATED_NODE != NV[cur][cell ]
               break
            iii. increment cell by 1
```

```
e. if cell >= end then
     popFilter()
f. else
       i. let down index is NV[cur][cell]
      ii. update top.position to cell+1 for next call to next
     iii. update stack by pushing and updating position
          pushFilter(cell)
      iv. set top.position to mask(_filterRC, 2δ)
       v. update top.current_node to down index
```

**ScanRow Algorithm**

```
1. create a stack
2. init the filter
     a. stack initFilter(r,0)
     b. update stack.top.current_node to root index
3. While stack is not empty
     a. If stack isBLDepth then
         We have a bitmap leaf
           i. yield all coordinate from BM[stack top current_node] using
              stack baseRow, baseColumn, and filter according to input
              parameter r
          ii. popFilter stack
     b. Else if NV[cursor][0] = VECTOR_LEAF then
     We have a coordinate vector leaf
           i. yield all coordinate from NV[stack top current_node] (may use
              stack baseRow and baseColumn), and filter according to input
              parameter r
          ii. popFilter stack
     c. Else
         We have a tree node
           i. Compute next stack state by invoking nextRow
```

*Algorithm for the Function "ScanColumn"*

In this algorithm, the input parameters are a row c to scan and the algorithm iterates over all leaves of the XAMTree using a breadth first traversal of the internal node TN. This algorithm is a refinement of scanColumnscanRow discussed above.

**Data structure:**

The implementations uses a same stack used in scanRow discussed above. But _filterRC is initialized by PartialEncode(Encodeδ (0, c, δ). The implementations extend the Stack described in ScanRow with the following operation:

```
1. nexColumn
   instead of scanning all cell of a TN scan only one column from, mask(_filterRC,
   2δ) to TNSIZE excluded by TNWIDTH step.
     a. let cur is top.current_node
     b. let cell is top.position
     c. skip in NV[cur] the next UNALLOCATED_NODE starting from cell, and
        update cell according
        repeat until break
          i. if cell >= TNSIZE then
             break
         ii. if UNALLOCATED_NODE != NV[cur][cell ]
             break
        iii. increment cell by TNWIDTH
     d. if cell >= TNSIZE then
```

```
            popFilter()
    e. else
          i. let down index is NV[cur][cell]
         ii. update top.position to cell+TNWIDTH for next call to next
        iii. update stack by pushing and updating position
             pushFilter(cell)
         iv. set top.position to mask(_filterRC, 2δ)
          v. update top.current_node to down index
```

## ScanColumn Algorithm

```
1. create a stack
2. init the filter
      a. stack initFilter(0,c)
4. While stack is not empty
      a. If stack isBLDepth then
           There is a bitmap leaf
                    1. yield all coordinate from BM[stack top current_node]
                       using stack baseRow, baseColumn, and filter
                       according to input parameter c
          ii. popFilter stack
      b. Else if NV[cursor][0] = VECTOR_LEAF then
           There is a coordinate vector leaf
           i. yield all coordinate from NV[stack top current_node] (may
              use stack baseRow and baseColumn), and filter according to
              input parameter c
          ii. popFilter stack
      c. Else
           There is a tree node
           i. Compute next stack state by invoking nextColumn
```

### Read-only version

The implementations may also comprise a read only version which is slightly different from the updatable (i.e., dynamic) version.

In the read-only version the data structure does not need any way to be updated (i.e., no set and reset operation are available). Furthermore, the implementations may store (i.e., create) a read-only version of the graph database by scanning a preexisting adjacency matrix, or from a XAMTree. The read-only variations of the implementations further optimize the memory usage for the storage.

The read-only version of the XAMTree is called ROXAMTree (Read-Only XAMTree).

### Read only memory layout

The fixed size of the tree nodes in the dynamic version, i.e., the defined $2^{2\delta}$ indices slots (i.e., TN) are rarely all used. Usually, the TN is sparse. Avoiding the indices slots to get full is important for an updatable data structure in order to keep O(1) update when a new node or leaf have to be created.

The implementations of the method may have a read-only implementation which avoid to pack a set of indices and to keep the sparsity of TN by using a bitmask ( see https://en.wikipedia.org/wiki/Mask_(computing) for bitmask) that represents the used indices. This bitmask is hereinbelow referred to as mn. For a given XAMTree with $\delta$=2, a 16 bits integer is enough to store this mask. For example, a tree node of 32bits integer may use 3 cells (e.g., the cells located at the positions 4, 7, and 8). Thereby the implementations only need 14 bytes (i.e., 2+3*4) to keep the information instead of 64 bytes (4*16). Similarly, a 16 bits bitmask may contain 0b0000'0001'1001'0000 ($2^4+2^7+2^8$) with indices 4, 7 and 8 in use. The position of the index associated to the cell can be computed using bit population count up to the tested cell (i.e., popcount(mn & ($2^{cell}$-1)), which returns 0, 1, and 2, for the indices 4, 7 and 8; respectively.

But it is possible to make a better use of the memory space. Like a XAMTree a ROXAMtree has two families of sub elements tree node and leaves. For instance, at BLDEPTH, the implementations may not replace bitmap leaves with other type of leaves. As a consequences, in the implementations the indices can omitted and the bitmap leaves are directly placed after mn.

For other level than BLDEPTH tree node mixing vector leaves and tree nodes is frequent, in order to avoid to have to keep indices pointing to this leaves, the implementations may use a second bitmask (called ml). Using the second bitmask helps to avoid to store the indices for all vector leaves. In the previous example if the tree node use the indices 4, 7, and 8 cells but 7 is a vector leaf. The ml bitmask will contains 0b0000'0000'1000'0000 ($2^7$), telling that just after the mask and (if any) TN indices there is a coordinate vector. In the implementations, the mn bitmask contains all sub element mask, while ml mask contains the leaves. It is trivial to obtain the tree node bitmask by performing an exclusive or between mn and ml.

In the read-only version, the implementations may also simplify vector nodes. One of the main constraints of the memory layouts (e.g., V32, V16, V8) discussed above for XAMTree is to keep them simple to be easily updatable and to be fit in the tree-node size.

In the case of a read-only data-structure, the implementations may only have to var-int serialize the delta of the sorted Morton encoded row column pairs (e.g., according to the method for compressing RDF tuples disclosed in European Patent Application No. 21306839.8 by Dassault Systèmes which is incorporated herein by reference). In order to keep the first-value as small as possible instead of initializing it at 0, the implementations use the Morton encoded coordinate of the node. Computing this coordinate is not an overhead because it has to be computed in order to scan properly BLs

_Tests_

The implementations are based on tests examining the capacity of the method of storing of a graph database, for example on Microsoft Academic Graph (https://www.microsoft.com/en-us/research/project/open-academic-graph/) which is a dataset of around 8 billion RDF triples. Such tests have observed the disclosed storing method outperform dynamic K2 tree (which experiences a degradation in term of performances and a write amplification) and an alternative solution using off-the-shelf data structures which exploits classical B+ Trees (which experiences significant increase in storage cost of the database).

A first test according to the following steps was conducted in order to compare XAMTree according to this disclosure with a dynamic version of K2-tree as described in BRISABOA, Nieves R. et al. "Compressed representation of dynamic binary relations with applications." Information Systems, 2017, vol. 69, p. 106-123 which is incorporated herein by reference:

- Importing the ChEMBL dataset (as provided in https://www.ebi.ac.uk/rdf/documentation/chembl/). This dataset is small enough (around 500M triples) to be usable with the K2Tree.
- Comparing the size used on a disk to store the database by the adjacency matrices for XAMTree and K2Tree.
- Comparing the elapse time of a small query involving a small adjacency matrix (3K triples) and on a big query involving big adjacency matrices (around 30 - 60M triples) to highlight the degeneracy of the K2Tree.

All operations of the above steps were done on a same hardware for both data structures, XAMTree and K2Tree, thereby the results are not dependent on hardware The results are provided in the following Table 5:

_Table 5- Comparative test results between XAMTree and K2Tree for ChEMBL dataset_

| Data structure used | XAMTree | K2Tree |
|---|---|---|
| Size used on disk for the adjacency matrices | 4.2 GiB | 1.8 GiB |
| Elapse time for a small (q0.sparql) | 46 ms | 51 ms |
| Elapse time for a big query (q1.sparql) | 6273 ms | 7809 ms |

In the results presented in Table 5, the comparison of the values of the second and the third column is more important than the absolute value of each of them. These results show that the XAMTree storage cost is in the same order of magnitude as with the dynamic k2-tree, while achieving better query times for big queries. Note that this experiment is run with a dataset more suitable K2Tree which means a K2Tree is usable and its lower storage cost can be preferred in regard to the gain in elapse time (20% in the experiment).

The small query (q0.sparql) used in the test is as follows:

```
Select (count(?s) as ?nb) { ?s cco:hasMechanism ?o },
and the big query (q1.sparql) in the test is as follows:
PREFIX rdf: <http://www.w3.org/1999/02/22-rdf-syntax-ns#>
PREFIX rdfs: <http://www.w3.org/2000/01/rdf-schema#>
```

```
PREFIX owl: <http://www.w3.org/2002/07/owl#>
PREFIX xsd: <http://www.w3.org/2001/XMLSchema#>
PREFIX dc: <http://purl.org/dc/elements/1.1/>
PREFIX dcterms: <http://purl.org/dc/terms/>
PREFIX foaf: <http://xmlns.com/foaf/0.1/>
PREFIX skos: <http://www.w3.org/2004/02/skos/core#>
PREFIX cco: <http://rdf.ebi.ac.uk/terms/chembl#>
PREFIX bibo: <http://purl.org/ontology/bibo/>
SELECT ?substance ?pubmedid ?sourceLabel ?assayType ?protein
WHERE {
    ?substance rdf:type cco:Substance .
    ?substance cco:hasDocument ?document .
        ?document bibo:pmid ?pubmedid .
    ?document cco:hasAssay ?assay .
    ?assay cco:assayType ?assayType .
        ?assay cco:hasSource ?source .
        ?source rdfs:label ?sourceLabel .
    ?assay cco:hasTarget ?target .
    ?target cco:hasTargetComponent ?targetcomponent .
    ?targetcomponent cco:targetCmptXref ?protein .
        ?protein a cco:UniprotRef
}
```

A second test was run with a bigger dataset of the Microsoft Academic Knowledge Graph (MAG) dataset (as provided in https://makg.org/rdf-dumps) which is made of around 8 billion triples. The second test results showed that XAMTree data structure enables importing the MAG in about 20 hours (ingestion throughput is 113428 triples/second), while with the dynamic K2tree the import is not finished after 40 hours on the same hardware. Thereby the K2Tree did not pass the criteria of throughput equal and above 50000 triples/second which was set as a failure threshold for the test. The results of the second test shows while XAMTree scale with the size of the graph database, the (dynamic) K2Tree does not.

## Claims

1. A computer-implemented method of storing RDF graph data in a graph database comprising a set of RDF tuples, the method comprising:

   - obtaining one or more adjacency matrices, each adjacency matrix representing a group of tuples of the graph database comprising a same predicate; and
   - storing, for each of the one or more adjacency matrices, a data structure comprising an array (NV), the array comprising:

     ◦ one or more indices each pointing to a sub-division of the adjacency matrix, and/or
     ◦ one or more elements each representing a group of tuples of the RDF graph database of a respective sub-division of the adjacency matrix.

2. The method of claim 1, each of the one or more elements of the array comprising:

   - a set of one or more coordinate pairs wherein each pair represents respective coordinates in the adjacency matrix.

3. The method of claim 2, wherein an element of the one or more elements comprises a data structure (V32) of 32-bit indices, and with a layout comprising:

   - a tag representing the size and/or a type of the data structure, and
   - one or more pairs of coordinates comprising a row and a column of the adjacency matrix.

4. The method of any of claims 2 to 3, wherein an element of the one or more elements comprises a data structure (V16) of 16-bit indices with a layout comprising:

- a tag representing the size and/or a type of the data structure, and
- one or more pairs of coordinates comprising a base column, a base row, an offset column, and an offset row of the adjacency matrix.

5. The method of any of claims 2 to 4, an element of the one or more elements comprises a data structure (V8) of 8-bit indices with a layout comprising:

- a tag representing the size and/or a type of the data structure, and
- one or more pairs of coordinates comprising a base column, a base row, an offset column, and an offset row of the adjacency matrix.

6. The method of claim 2, wherein an element of the one or more elements comprises a data structure (Vm) of m-bit indices, the method further comprising:

- determining a tag corresponding to the element and based on the one or more pairs of coordinates, the tag representing the size and/or a type of a data structure.

7. The method of any of claims 1 to 6, the stored data structure further comprising a bit array (BM) of bitmap representation of a group of RDF tuples in a respective sub-division of the adjacency matrix.

8. The method of any of claims 1 to 7, the array of the stored data structure being a 2D array of size $2^n \times 2^n$ or a 1D array of size $2^{2n}$, n being a positive integer.

9. The method of any of claims 1 to 8, wherein the storing the data structure comprises:

- allocating a slot thereby obtaining a root index, the root index representing a location of the tree data structure in a memory; and
- setting the array at the root index to an array of coordinate pairs.

10. The method of any of claims 1 to 9, wherein the method of storing an RDF graph further comprises implementing one or more of the following functions on the RDF graph database, each function being configured to apply on each adjacency matrix of the one or more adjacency matrices:

- a function (Test) configured to check if a given cell of the adjacency matrix is set to a first specified value,
- a function (Set) configured to set a given cell of the adjacency matrix to a first specified value,
- a function (Reset) configured to set a given cell of the adjacency matrix to a second specified value,
- a function (ScanAll) configured to output respective coordinates of all cells of the adjacency matrix with a first specified value,
- a function (ScanRow) configured to output respective coordinates of cells of a given row in the adjacency matrix with a first specified value, and/or
- a function (ScanColumn) configured to output respective coordinates of cells of a given column in the adjacency matrix with a first specified value.

11. The method of any of claims 1 to 10, wherein the obtaining one or more adjacency matrices comprises performing a vertical partitioning for each predicate of the graph database.

12. A computer program comprising instructions for performing the method of any of claims 1 to 11.

13. A computer readable storage medium having recorded thereon a computer program of claim 12.

14. A system comprising a processor coupled to a memory, the memory having recorded thereon the computer program of claim 12.

obtaining one or more adjacency matrices, each adjacency matrix representing a group of tuples of the graph database comprising a same predicate

S10

storing, for each of the one or more adjacency matrices, a data structure comprising an array (NV), the array comprising one or more indices each pointing to a sub-division of the adjacency matrix, and/or one or more elements each representing a group of tuples of the RDF graph database of a respective sub-division of the adjacency matrix.

S20

## FIG. 1

FIG. 2

| Example of V32 memory layout | | | | | | | |
|---|---|---|---|---|---|---|---|
| | 1 | 2 | 3 | 4 | 5 | 6 | 7 |
| VECTOR_LEAF | | | | V32TAG | size | maxSize | |
| R0 | | | | C0 | | | |
| R1 | | | | C1 | | | |
| R2 | | | | C2 | | | |
| R3 | | | | C3 | | | |
| R4 | | | | C4 | | | |
| R5 | | | | C5 | | | |
| R6 | | | | C6 | | | |

## FIG. 3A

| Example of V32 memory layout | | | | | | | |
|---|---|---|---|---|---|---|---|
| 0 | 1 | 2 | 3 | 4 | 5 | 6 | 7 |
| VECTOR_LEAF | | | | V32TAG | size | maxSize | |
| RC0 | | | | | | | |
| RC1 | | | | | | | |
| RC2 | | | | | | | |
| RC3 | | | | | | | |
| RC4 | | | | | | | |
| RC5 | | | | | | | |
| RC6 | | | | | | | |

## FIG. 3B

| Example of V16 memory layout | | | | | | | |
|---|---|---|---|---|---|---|---|
| 0 | 1 | 2 | 3 | 4 | 5 | 6 | 7 |
| VECTOR_LEAF | | | | V16TAG | size | maxSize | |
| Rbase | | Cbase | | Ro0 | | Co0 | |
| Ro1 | | Co1 | | Ro2 | | Co2 | |
| | | | | | | | |
| | | | | | | | |
| | | | | | | | |
| | | | | | | | |
| | | | | Ro12 | | Co12 | |

## FIG. 4

| Example of V8 memory layout | | | | | | | |
|---|---|---|---|---|---|---|---|
| 0 | 1 | 2 | 3 | 4 | 5 | 6 | 7 |
| VECTOR_LEAF | | | | V8TAG | size | maxSize | |
| Rbase | | | | Cbase | | | |
| Ro0 | Co0 | Ro1 | Co1 | | | | |
| | | | | | | | |
| | | | | | | | |
| | | | | | | | |
| | | | | | | | |
| | | | | | | $Ro_{max}$ | $Co_{max}$ |

## FIG. 5

```
node_size = 64*8
header_size = 64
index_bitsize = 32
print("type","index","base", "max capacity", sep=" | ")
print("====","=====","====", "============", sep=" | ")
for n in range(4,index_bitsize+2,2):
   print("V{0}".format(n), n ,index_bitsize - n,
           ((node_size - header_size)
           -(2*(index_bitsize-n)))//(2*n), sep = " | " )

print("type is the Vnn type")
print("index is index bitsize for r and c in the Vnn")
print("base is minimal base bitsize for r and c in the Vnn")
print("max capacity is maximal number of r,c pairs can be stored in Vnn")
print("Only even bitsize are reported")
print("this is because delta = 2, each level in the tree consumes 2 bits")
```

# FIG. 6A

| Type | Index | Base | Max Capacity |
|------|-------|------|--------------|
| V4 | 4 | 28 | 49 |
| V6 | 6 | 26 | 33 |
| V8 | 8 | 24 | 25 |
| V10 | 10 | 22 | 20 |
| V12 | 12 | 20 | 17 |
| V14 | 14 | 18 | 14 |
| V16 | 16 | 16 | 13 |
| V18 | 18 | 14 | 11 |
| V20 | 20 | 12 | 10 |
| V22 | 22 | 10 | 9 |
| V24 | 24 | 8 | 9 |
| V26 | 26 | 6 | 8 |
| V28 | 28 | 4 | 7 |
| V30 | 30 | 2 | 7 |
| V32 | 32 | 0 | 7 |

## FIG. 6B

**EP 4 386 574 A1**

Europäisches
Patentamt

European
Patent Office

Office européen
des brevets

# EUROPEAN SEARCH REPORT

Application Number

EP 22 30 6928

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ÁLVAREZ-GARCÍA SANDRA ET AL: "Compressed vertical partitioning for efficient RDF management", KNOWLEDGE AND INFORMATION SYSTEMS, SPRINGER VERLAG, LONDON, GB, vol. 44, no. 2, 1 August 2014 (2014-08-01), pages 439-474, XP035510109, ISSN: 0219-1377, DOI: 10.1007/S10115-014-0770-Y [retrieved on 2014-08-01] * section 3.3; figure 3 * * section 4.2; figure 5 * * section 5 * ----- | 1-14 | INV. G06F16/22 H03M7/40 |

TECHNICAL FIELDS SEARCHED (IPC)

G06F
H03M

The present search report has been drawn up for all claims

| Place of search | Date of completion of the search | Examiner |
|---|---|---|
| The Hague | 9 May 2023 | Bercan, Radu |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 21306839

### Non-patent literature cited in the description

- *Microsoft Academic Knowledge Graph.,* 10 May 2022, https://makg.org/rdf-dumps
- **ÁLVAREZ-GARCÍA, S. et al.** Compressed vertical partitioning for efficient RDF management. *Knowledge and Information Systems,* 2015, vol. 44 (2), 439-474
- Exploiting topological structures for graph compression based on quadi-rees. **CHATTERJEE, A. et al.** 2016 Second International Conference on Research in Computational Intelligence and Communication Networks (ICRCICN). IEEE, 2016, 192-197
- Queryable compression on streaming social networks. **NELSON, M. et al.** IEEE International Conference on Big Data (Big Data). IEEE, 2017, 988-993
- RDF 1.1 Concepts and Abstract Syntax. *W3C Recommendation,* 25 February 2014

- **ABADI, D.J. et al.** Scalable semantic web data management using vertical partitioning. *Proceedings of the 33rd international conference on Very large databases,* September 2007, 411-422
- **KERSTEN, T. et al.** Everything you always wanted to know about compiled and vectorized queries but were afraid to ask. *Proceedings of the VLDB Endowment,* 2018, vol. 11 (13), 2209-2222
- *Microsoft Academic Graph, https://www.microsoft.com/en-us/research/project/open-academic-graph/*
- **BRISABOA, NIEVES R. et al.** Compressed representation of dynamic binary relations with applications. *Information Systems,* 2017, vol. 69, 106-123